(19) Europäisches Patentamt
European Patent Office
Office européen des brevets

(11) **EP 2 279 549 B1**

(12) **EUROPÄISCHE PATENTSCHRIFT**

(45) Veröffentlichungstag und Bekanntmachung des Hinweises auf die Patenterteilung:
**01.08.2012 Patentblatt 2012/31**

(21) Anmeldenummer: **09729950.7**

(22) Anmeldetag: **08.04.2009**

(51) Int Cl.:
*H02H 7/08* (2006.01)  *G01R 31/34* (2006.01)

(86) Internationale Anmeldenummer:
**PCT/DK2009/000088**

(87) Internationale Veröffentlichungsnummer:
**WO 2009/124549 (15.10.2009 Gazette 2009/42)**

(54) **VERFAHREN ZUM ERFASSEN EINES FEHLERS IN EINER DREHFELDMASCHINE**

METHOD FOR DETECTING AN ERROR IN AN INDUCTION MACHINE

PROCÉDÉ DE DÉTECTION D'UNE ERREUR DANS UNE MACHINE À INDUCTION

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **09.04.2008 DE 102008017900**

(43) Veröffentlichungstag der Anmeldung:
**02.02.2011 Patentblatt 2011/05**

(73) Patentinhaber: **Danfoss Drives A/S
6300 Graasten (DK)**

(72) Erfinder: **SIMON, Karl-Peter
D-67269 Grünstadt (DE)**

(74) Vertreter: **Knoblauch, Andreas
Patentanwälte Dr. Knoblauch
Schlosserstrasse 23
60322 Frankfurt am Main (DE)**

(56) Entgegenhaltungen:
**US-A- 5 644 458**

• **ALBERTO BELLINI, FIORENZO FILIPPETTI, GIOVANNI FRANCESCHINI: "Closed-Loop Control Impact on the Diagnosis of Induction Motors Faults" IEEE TRANSACTIONS ON INDUSTRY APPLICATIONS, IEEE SERVICE CENTER, PISCATAWAY, NJ, US, Bd. 36, Nr. 5, 1. September 2000 (2000-09-01), XP011022821 ISSN: 0093-9994**
• **BELLINI ALBERTO, FIORENZO FILIPPETTI, GIOVANNI FRANCESCHINI, CARLA TASSONI: "Classification of diagnostic indexes for field oriented induction motor drives" IEEE INTERNATIONAL SYMPOSIUM ON DIAGNOSTICS FOR ELECTRIC MACHINES, POWER ELECTRONICS AND DRIVES 24-26 AUG. 2003 ATLANTA, GA, USA, 2003, Seiten 217-222, XP002532822 IEEE International Symposium on Diagnostics for Electric Machines, Power Electronics and Drives (IEEE Cat. No.03EX685) IEEE Piscataway, NJ, USA ISBN: 0-7803-7838-5**
• **CRUZ S. M. A., CARDOSO A. J. M.: "Diagnosis of rotor faults in direct and indirect FOC induction motor drives" 2007 EUROPEAN CONFERENCE ON POWER ELECTRONICS AND APPLICATIONS 2-5 SEPT. 2007 AALBORG, DENMARK, 2007, Seiten 4554-4563, XP002532823 2007 European Conference on Power Electronics and Applications IEEE Piscataway, NJ, USA ISBN: 978-90-75815-10-8**

## Beschreibung

Die Erfindung betrifft ein Verfahren zum Erfassen eines Fehlers in einer Drehfeldmaschine, bei dem man Stromkomponenten in einem flussfesten, insbesondere rotorflussfesten Koordinatensystem auswertet.

Ein derartiges Verfahren ist beispielsweise aus US 5 644 458 bekannt. Hier werden Statorspannungen, Statorströme und Statorflüsse von einem 3-phasigen in das statorfeste 2-phasige Koordinatensystem transformiert. Anschließend erfolgt eine weitere Transformation in das rotorfeste Koordinatensystem mit Bezug auf den Rotorfluss. Diese transformierten Größen werden in einem Motormodell mit festen Parametern weiter verknüpft. Die in diesem Modell voraus berechneten Stromkomponenten werden mit den aktuellen Stromkomponenten verglichen. Bei Abweichungen, die größer sind als ein bestimmter Prozentsatz im Bereich von 1 % bis 25 %, wird von einem unspezifizierten Fehler im Motor ausgegangen.

US 6 822 839 B2 beschreibt ebenfalls die allgemein bekannte Koordinatentransformation von einem 3-phasigen Drehstromsystem in ein Zwei-Achsen-System. Eine weitere Transformation wird durchgeführt, um eine Aussage über die Wirkleistung und die Blindleistung zu erhalten. Anhand der gesamten Motor-Blindleistung wird eine Fehlererkennung durchgeführt. Diese ist bei belastetem Motor aber nur wenig aussagekräftig.

Das Dokument "Closed-loop Control Impact on the Diagnosis of Induction Motors Faults", IEEE Transactions on Industry Applications, Vol. 36, No.5, September/October 2000, offenbart ein Verfahren zum Erfassen eines Fehlers in einer Drehfeldmaschine gemäss dem Oberbegriff des Anspruchs 1.

Der Erfindung liegt die Aufgabe zugrunde, auf einfache Weise Fehler frühzeitig erkennen zu können.

Diese Aufgabe wird bei einem Verfahren der eingangs genannten Art dadurch gelöst, dass man eine flussbildende Stromkomponente im flussfesten, insbesondere rotorflussfestem Koordinatensystem einer Frequenzanalyse unterzieht, wobei man für mindestens eine vorbestimmte Speisefrequenz einen aktuellen Betriebspunkt ermittelt und diesen Betriebspunkt mit einem früheren Betriebspunkt vergleicht.

Man wertet also im flussfesten, insbesondere rotorflussfesten Koordinatensystem von den orthogonalen Stromkomponenten $i_{vekd}$ und $i_{vekq}$ die erstgenannte Stromkomponente aus, die das Magnetfeld steuert. Die letztgenannte Komponente steuert das Drehmoment.

Jedem magnetischen Fluss lässt sich eine Induktivität zuordnen. Bei einem Statorwicklungsfehler mit teilweisem Windungsschluss, also einem Isolationsverlust zwischen einzelnen Windungen eines Wicklungsstranges, verändert sich beispielsweise die Induktivität in dem entsprechenden Wicklungsstrang. Die nicht mehr in allen drei Strängen symmetrischen Induktivitäten rufen eine Pulsation der flussbildenden Stromkomponente $i_{vekd}$ hervor, und zwar mit doppelter Speisefrequenz. Bei im Fehlerfall nicht mehr konstantem Magnetfluss tritt auch im Drehmoment bzw. der diesem proportionalen Stromkomponente $i_{vekq}$ eine Pulsation mit doppelter Speisefrequenz auf. Mit zunehmender Motorbelastung verringert sich jedoch bei unverändertem Wicklungsfehler die Amplitude der doppelten Speisefrequenz im Drehmomentverlauf, so dass der Wicklungsfehler unter Last mit diesem Signal praktisch nicht mehr delegierbar wird. Die flussbildende Stromkomponente $i_{vekd}$ ist von der Drehmomenthöhe jedoch weitgehend unabhängig, so dass die Fehlerdetektion mit diesem Stromwert auch unter Nennlast einwandfrei gewährleistet ist.

Man ermittelt für mindestens eine vorbestimmte Speisefrequenz einen aktuellen Betriebspunkt und vergleicht diesen Betriebspunkt mit einem früheren Betriebspunkt. Man verwendet also zur Beurteilung einen Vergleich zu verschiedenen Zeitpunkten zwischen aktuellen Daten und Referenzdaten. Ein derartiger Vergleich ergibt eine höhere Beurteilungssicherheit als die Verwendung von Absolutwerten. Die gewählten Betriebspunkte entsprechen dabei vorzugsweise den im Arbeits- oder Antriebseinsatz tatsächlich auftretenden Betriebspunkten.

Bevorzugterweise entspricht der frühere Betriebspunkt einem fehlerfreien Zustand der Maschine. Beispielsweise kann man davon ausgehen, dass die Maschine im Auslieferungszustand fehlerfrei ist. Der Bezug des aktuellen Betriebspunkts zu einem fehlerfreien Betriebspunkt gestattet eine sehr sensible Fehlerdiagnose weit unterhalb eines Zustands, bei dem die Maschine betriebsunfähig wird.

Vorzugsweise verwendet man für die Frequenzanalyse eine Fast-Fourier-Transformation. Mit einer Fast-Fourier-Transformation (FFT) lässt sich das Frequenzspektrum, das in der flassbildenden Stromkomponente vorliegt, relativ schnell und sicher erhalten. Anhand dieses Frequenzspektrums kann man dann beurteilen, ob die Maschine fehlerbehaftet ist oder nicht.

Vorzugsweise führt man die Fast-Fourier-Transformation für Messwerte innerhalb eines Zeitfensters mit vorbestimmter Länge durch. Man gewinnt also in diskreten Zeiträumen die Frequenzinformation. Dementsprechend kann man die gewonnenen Analysewerte in Datensätzen erfassen und der Reihe nach abspeichern. Die Länge eines derartigen Zeitpunktes liegt beispielsweise im Bereich von 3 bis 5 Sekunden.

Vorzugsweise hält man die Speisefrequenz innerhalb des Zeitfensters konstant. Dies lässt sich in einem Zeitfenster einer begrenzten Länge ohne weiteres realisieren. Sollte sich die Speisefrequenz in diesem Zeitfenster ändern, wird der entsprechende Datensatz verworfen.

Auch ist bevorzugt, wenn man eine symmetrische Spannung innerhalb des Zeitfensters beibehält. Auch diese Bedingung lässt sich ohne weiteres erfüllen, wenn das Zeitfenster eine begrenzte Länge hat. Wenn sich die Symmetrie ändert, dann wird der entsprechende Datensatz verworfen. Hier ist nur wichtig, dass die Phasenspannungen symmetrisch sind. Die Höhe der Spannungen wird hier nicht benötigt.

Vorzugsweise berechnet man mindestens eine kritische Frequenz und wertet das Frequenzspektrum bei dieser kritischen Frequenz aus. Man muss also nicht das gesamte Frequenzspektrum, das durch die Fast-Fourier-Transformation gewonnen worden ist, auswerten. Für die Erfassung eines Fehlerfalles kann man sich vielmehr auf eine oder wenige kritische Frequenzen beschränken.

Hierbei ist bevorzugt, dass man als kritische Frequenz $f_k$ für einen Statorfehler $f_k = 2 \cdot f_{sp}$ und für einen Rotorwicklungsfehler $f_k = 2(f_{sp} - n \cdot p)$ ermittelt, wobei $f_{sp}$ die Speisefrequenz, n die Rotordrehzahl und p die Anzahl der Polpaare ist. Damit trägt man der Tatsache Rechnung, dass die flussbildende Stromkomponente bei einem Statorfehler mit der doppelten Speisespannung pulsieren wird. Bei einem Rotorwicklungsfehler einer Asynchronmaschine berücksichtigt man zusätzlich noch den Schlupf.

Vorzugsweise gewinnt man die benötigten Größen aus Betriebsdaten eines Frequenzumrichters. Wenn der Frequenzumrichter in der Betriebsart Vektorregelung oder erweiterte Spannungsvektorregelung (vvc plus, voltage vector control plus) betrieben wird, dann stehen die benötigten Daten ohnehin zur Verfügung, d. h. man benötigt keine weiteren Sensoren, um die Fehlerüberwachung durchführen zu können. Die Fehlerüberwachung lässt sich vielmehr anhand der ohnehin vorhandenen Messwerte durchführen.

Die Erfindung wird im Folgenden anhand eines bevorzugten Ausführungsbeispiels in Verbindung mit der Zeichnung beschrieben. Hierin zeigen:

**Fig. 1** eine stark schematisierte Darstellung eines Asynchronmotors mit einem Frequenzumrichter,

**Fig. 2** ein Zeigerdiagramm zur Erläuterung einiger Stromkomponenten,

**Fig. 3** eine statistische Verteilung von Referenzwerten,

**Fig. 4** eine schematische Erläuterung zur Fehlererfassung,

**Fig. 5** ein FFT-Spektrum des Drehmoments,

**Fig. 6** ein FFT-Spektrum der flussbildenden Stromkomponente und

**Fig. 7** ein Flussdiagramm.

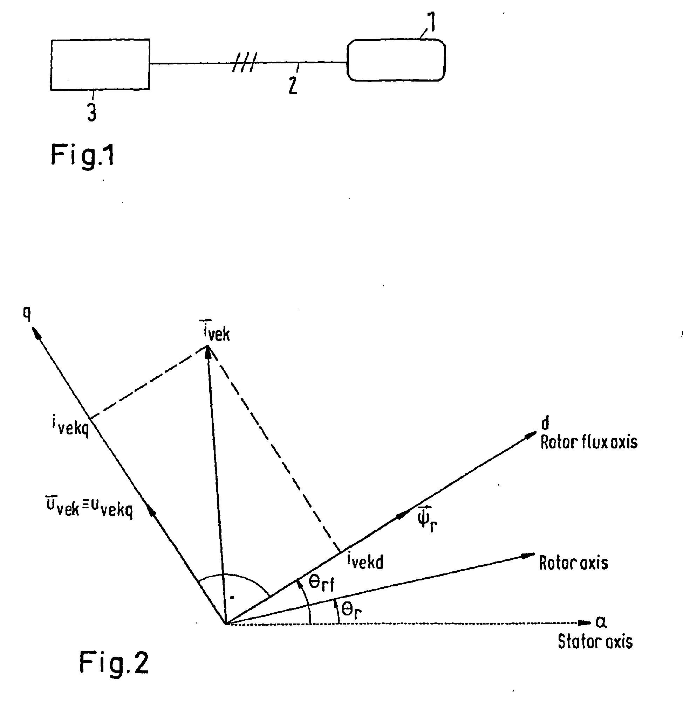

Fig. 1. zeigt schematisch einen Asynchronmotor 1, der über eine 3-phasige Leitung 2 mit einem Frequenzumrichter 3 verbunden ist. Die Leitung 2 kann eine Länge von bis zu 150 m aufweisen. Der Frequenzumrichter 3 versorgt den Asynchronmotor 1 in an sich bekannter Weise mit einem 3-phasigen Drehstrom, der im Ständer des Asynchronmotors 1 ein Drehfeld erzeugt.

Obwohl Asynchronmotoren in der Regel relativ robust ausgeführt sind, können Fehler auftreten, beispielsweise ein Isolationsverlust in der Statorwicklung oder ein Stabbruch in der Rotorwicklung. Derartige Fehler führen vielfach nicht unmittelbar dazu, dass die Maschine ausfällt. Vielmehr kann der Motor weiter betrieben werden. Man möchte aber frühzeitig eine Information über einen Fehlerfall erhalten, so dass man bei einer ohnehin vorgesehenen Wartungspause den Motor reparieren oder austauschen kann.

Wenn im Folgenden von "Motor" die Rede ist, dann gilt die Fehlerdiagnose in entsprechender Weise auch dann, wenn die Maschine als Generator betrieben wird.

Wenn der Frequenzumrichter 3 in der Betriebsart Vektorregelung oder VVC plus (voltage vector control plus) betrieben wird, dann stehen einige Daten zur Verfügung, die man für die Fehlerdiagnose verwenden kann. Zusätzliche Sensoren, Detektoren oder dergleichen sind also nicht erforderlich, um einen Fehler zu erfassen.

Für die Fehlerdiagnose werden die im Frequenzumrichter 3 vorliegenden Raumvektoren, also Statorstromkomponenten, im rotorflussfesten Koordinatensystem ausgewertet. In einem Koordinatensystem mit festem Bezug zum magnetischen Fluss $\psi_r$ lassen sich orthogonale Stromkomponenten $i_{vekd}$ und $i_{vekq}$ gewinnen. Hierbei ist $i_{vekd}$ parallel zum Rotorfluss gerichtet und steuert das Magnetfeld. $i_{vekq}$ ist senkrecht zur Stromkomponente $i_{vekd}$ gerichtet und steuert das Motordrehmoment.

Der Frequenzumrichter 3 kann in der Betriebsart Vektorregelung bzw. VVC plus den erforderlichen Winkel $\theta_{rf}$ zur Festlegung des drehenden Koordinatensystems (d, q) gegenüber dem Statorwicklungsstrang $\alpha$ ohne mechanische Sensoren berechnen. Ein Zusammenhang zwischen Motordrehmoment M und $i_{vekq}$ wird durch Gleichung (1) bestimmt.

$$M = \frac{3}{2} \cdot p \cdot \frac{L_m}{L_r} \cdot \psi_r \cdot i_{vekq} \quad (1)$$

In Gleichung (1) ergibt sich der Rotorfluss $\psi_r$ mit $i_{vekd}$ und weiteren Motorparametern zu

$$\psi_r = \frac{L_m}{1 + \tau_r \cdot s} \cdot i_{vekd}; \quad \tau_r = \frac{L_r}{R_r} \quad (2)$$

Dabei ist s der Laplace-Operator entsprechend der regelungstechnischen Darstellung eines Verzögerungsgliedes der 1. Ordnung.

Jedem magnetischen Fluss lässt sich eine Induktivität zuordnen. Bei einem Statorwicklungsfehler mit teilweisem Windungsschluss verändert sich die Induktivität in dem entsprechenden Wicklungsstrang. Die nicht mehr in allen drei Strängen symmetrischen Induktivitäten rufen eine Pulsation der flussbildenden Stromkomponente $i_{vekd}$ mit doppelter Speisefrequenz hervor. Bei im Fehlerfall nicht mehr konstantem Magnetfluss tritt auch im Drehmoment bzw. der diesem proportionalen Stromkomponente $i_{vekq}$ eine Pulsation mit doppelter Speisefrequenz auf.

Mit zunehmender Motorbelastung verringert sich jedoch bei unverändertem Wicklungsfehler die Amplitude der doppelten Speisefrequenz im Drehmomentverlauf, so dass der Wicklungsfehler unter Last mit Hilfe der Pulsation im Drehmomentverlauf praktisch nicht mehr detektierbar wird. Die flussbildende Stromkomponente $i_{vekd}$ ist von der Drehmomenthöhe jedoch weitgehend unabhängig, so dass die Fehlerdetektion mit diesem Stromwert auch unter Nennlast einwandfrei gewährleistet ist.

Ein wichtiger Unterschied in der Aussagekraft zwischen Drehmoment und $i_{vekd}$ besteht im Bereich der Motorspeisefrequenz. Während unterhalb der Motornennfrequenz mit der FFT schon bei halber Nennlast kaum ein Unterschied zwischen einwandfreier und fehlerbehafteter Statorwicklung erkennbar ist, liefert die FFT von $i_{vekd}$ bei gleicher Last noch unterhalb der halben Nennfrequenz des Motors eine einwandfreie Fehlerkennung.

Für die Fehlererfassung verwendet man also lediglich folgende Messgrößen: Die Motorstromkomponente $i_{vekd}$ im flussfesten Koordinatensystem, die Motorspeisefrequenz $f_{sp}$, die Motordrehzahl n (wenn man einen Rotorfehler erfassen will) und das Drehmoment M aus Gleichung (1), ersatzweise die entsprechende Stromkomponente $i_{vekq}$.

Für jede aktuelle Belastung bei einer Speisefrequenz $f_{sp}$ wird ein Verhältnis des aktuellen Moments zum Nennmoment ($M/M_n$) berechnet. Der Messwert $i_{vekd}$ wird last- und frequenzabhängig bzgl. seiner Amplitude (Betragshöhe) mit Hilfe der Fast-Fourier-Transformation (FFT) ausgewertet.

Die Auswertung der Messdaten erfolgt durch Vergleich zweier Betriebszustände, von denen einer dem "gesunden", also fehlerfreien Motorzustand entsprechen sollte. Der Bezug des aktuellen Betriebspunkts zu einem Referenzzustand gestattet eine sehr sensible Fehlerdiagnose weit unterhalb eines Zustands, bei dem der Motor betriebsunfähig wird.

Für eine hohe Beurteilungssicherheit bzgl. des Isolationszustands der Motorwicklung ist der Vergleich der Daten des aktuellen Betriebspunkts mit Daten aus einer Basis- oder Referenzmessung, bei der die Wicklung noch fehlerfrei ist, außerordentlich hilfreich. Ohne Referenzmessung müssten die Kriterien als Absolutwerte ausgewertet werden, was unter Umständen eine weniger sensible Fehlerdiagnostik bedeutet.

Alle relevanten Daten werden sowohl bei der Referenzmessung als auch bei den später folgenden Analysemessungen in Abhängigkeit vom Belastungszustand und der Speisefrequenz des Motors gespeichert.

Die FFT wird für Messwerte innerhalb eines bestimmten Zeitfensters von beispielsweise vier Sekunden durchgeführt und dann bei bestimmten Frequenzen, die weiter unten angegeben werden, ausgewertet.

Innerhalb des Zeitfensters sollte die Speisefrequenz $f_{sp}$ konstant bleiben. Kleinere Schwankungen innerhalb eines Bereichs $\pm \Delta f$ sind zulässig. Weiterhin sollten die Spannungen des vom Frequenzumrichter gelieferten Drehstromsystems symmetrisch sein. Wenn diese Voraussetzungen nicht vorliegen, wird der entsprechende Datensatz verworfen. Es erfolgt grundsätzlich eine statistische Auswertung mehrerer Datensätze.

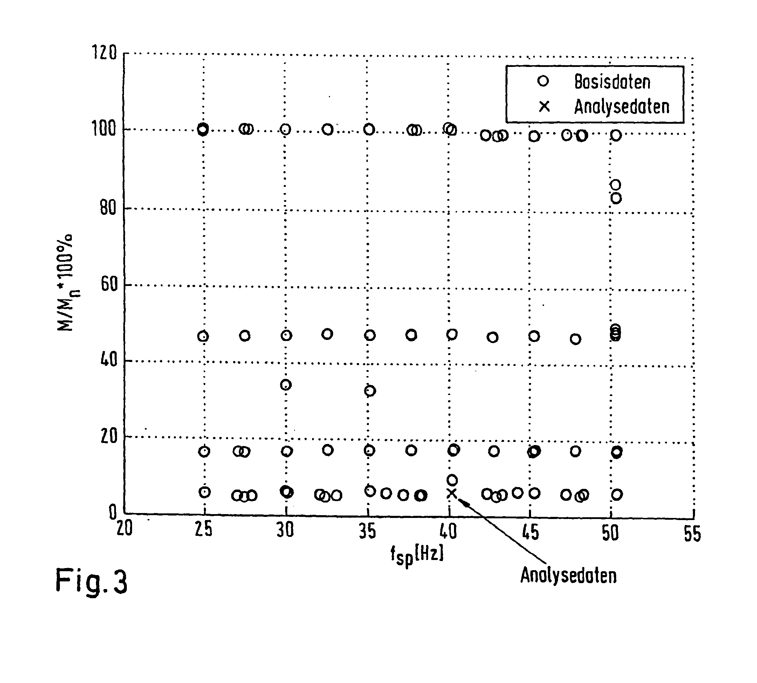

Für die Statorfehleranalyse ist eine beliebige Motorbelastung zwischen Leerlauf und Nennlast möglich. Fig. 3 zeigt eine statistische Verteilung von Betriebspunkten mit $i_{vekd}$-Referenzdaten bei unterschiedlichen Frequenzen und unterschiedlichen Lastzuständen, die mit einem Kreis gekennzeichnet sind. Diese Basisdaten sind bei einer fehlerfreien Maschine ermittelt worden.

Fig. 3 zeigt eine statistische Verteilung von Betriebspunkten bei einer bestimmten Last $M/M_n$ und einer bestimmten Motorfrequenz $f_{sp}$ im Referenzfall. Für jeden Messpunkt, der durch einen Kreis dargestellt ist, wird im Pro-

grammablauf M/M$_n$, f$_{sp}$, n, sowie die Amplitude der FFT von i$_{vekd}$ bei 2*f$_{sp}$ für einen Messzyklus über 4s abgespeichert.

Wird nach der Aufnahme der Referenzdaten (o) auf Analysemodus umgeschaltet, werden die gleichen Daten neu gespeichert und die statistische Verteilung der Betriebspunkte bezüglich Last und Speisefrequenz mit einem x im gleichen Bild dargestellt. Die Fehleraussage erfolgt jetzt durch Vergleich der i$_{vekd}$-Werte zwischen Referenz- und Analysespeicher.

Liegen o- und x-Werte zusammen, so heißt das konkret, dass ein Vergleich der damit verknüpften i$_{vekd}$-Werte möglich ist. Ein geringer Unterschied der Betriebspunkte zwischen Belastung und Speisefrequenz von Referenz- und Analysedaten ist zulässig. Gibt es für Betriebspunkte im Analysemodus keine in der "Nähe" liegenden Referenzdaten, wird die Fehleraussage unterdrückt.

Fig. 3 liefert also nur eine Übersicht, an welchen Betriebspunkten eine Fehleraussage durch Vergleich möglich ist.

Das Kreuz in Fig. 3 zeigt die Aufzeichnung aller relevanten Messgrößen im Analysemdous für den beispielhaft gewählten Betriebspunkt mit ca. 5 % Last und 40 Hz.

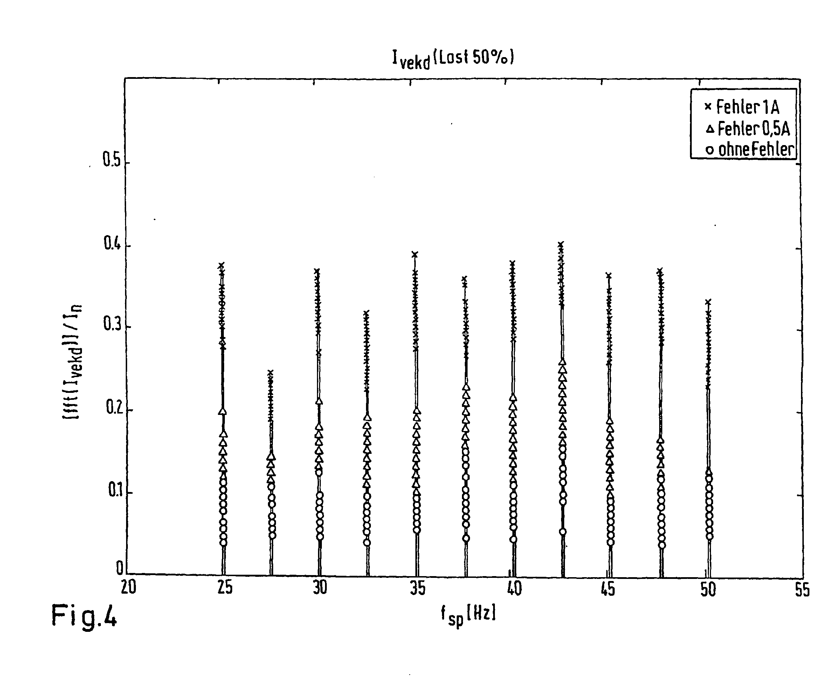

Wie aus Fig. 4 hervorgeht, ist die Analyse der Stromkomponente i$_{vekd}$ außerordentlich aussagekräftig. Aufgetragen ist von links nach rechts die Speisefrequenz f$_{sp}$ und nach oben das Verhältnis der entsprechenden Stromkomponente aus der Fast-Fourier-Transformation bezogen auf den Nennwert des Stromes.

Man kann erkennen, dass es einen deutlichen Unterschied zwischen Fehlerwerten bei einem Fehlerstrom von 1 A und dem fehlerfreien Fall gibt. Auch bei einem kleinen Fehlerstrom von 0,5 A (mit Dreiecken eingezeichnet) ist der Fehlerfall noch deutlich vom fehlerfreien Fall zu unterscheiden. In beiden Fällen ist der Motor noch voll funktionsfähig.

Man muss nach der Fast-Fourier-Transformation nicht das gesamte Frequenzspektrum untersuchen. Wie oben erwähnt, reicht es aus, wenn man nur die kritische Frequenz f$_k$ untersucht. Die Größe dieser Frequenz richtet sich danach, ob man einen Fehler im Stator oder im Rotor untersuchen möchte.

Für einen Statorwicklungsfehler ergibt sich dann

$$f_k = 2 \cdot f_{sp}$$

Für einen Rotorwicklungsfehler ergibt sich

$$f_k = 2 \cdot (f_{sp} - n \cdot p)$$

Hierbei ist f$_{sp}$ die Speisefrequenz, n die Drehzahl des Rotors und p die Polpaarzahl des Motors.

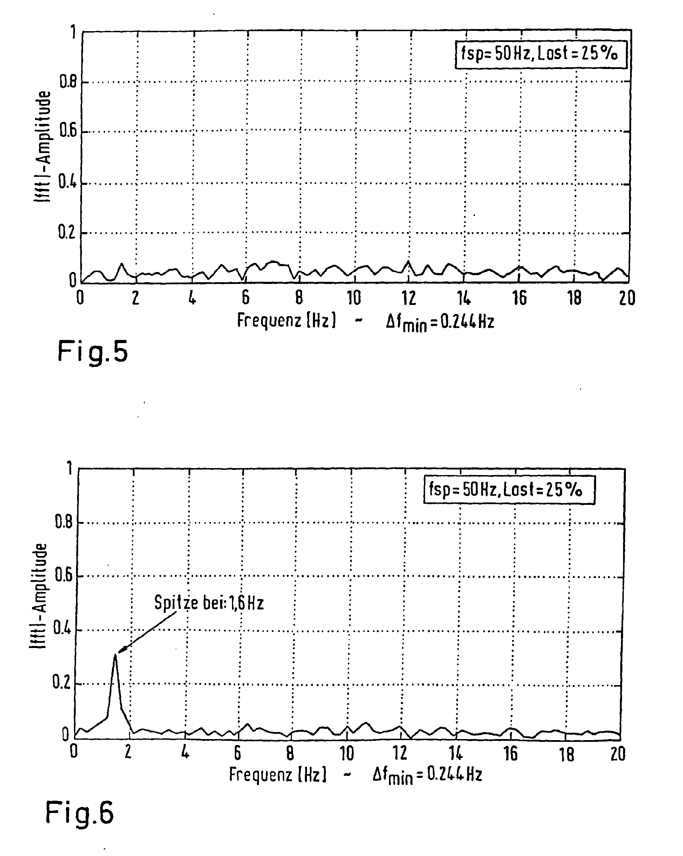

Die Figuren 5 und 6 zeigen, wie wirksam die Analyse der Stromkomponente i$_{vekd}$ auch bei Rotor-Wicklungsfehlern ist (Fig. 6) gegenüber der bekannten Drehmomentanalyse (Fig. 5), die praktisch keine Fehlerdetektion bei geringer Belastung mit 25 % mehr zulässt.

Fig. 5 zeigt die mit einer Fast-Fourier-Transformation gewonnene Spektralverteilung im Drehmoment M. Es lässt sich praktisch bei keiner Frequenz eine signifikante Aussage darüber treffen, ob ein Fehler vorliegt oder nicht.

Fig. 6 zeigt die Spektralverteilung, die man aus der Fast-Fourier-Transformation der Stromkomponente i$_{vekd}$ gewonnen hat. Hier ist eine Spitze bei 1,6 Hz deutlich zu erkennen. Dies ist eine Spitze bei der kritischen Frequenz f$_k$ für den entsprechenden Betriebszustand des AsynchronMotors. Eine derartige Fehlerermittlung ist bereits bei einer geringen Motorbelastung von 25 % des Nennmoments möglich.

Für die Diagnose der Maschine wird daher mit der Fast-Fourier-Transformation die Spektralverteilung der Magnetisierungs-Stromkomponente i$_{vekd}$ ermittelt und das Ergebnis als

$$\text{Beurteilungsfaktor} = (\text{FFT}(i_{vekd}(\text{defekter Motor})))/\text{FFT}(i_{vekd}(\text{gesunder Motor})) \cdot 100\%$$

statistisch gemittelt für jede beliebige aktuelle Motorlast ausgegeben.

Je nach Schwere des Isolationsverlustes in der Statorwicklung steigt dieser Faktor vom "gesunden" Wert 100 % auf Werte bis zu 500 % an.

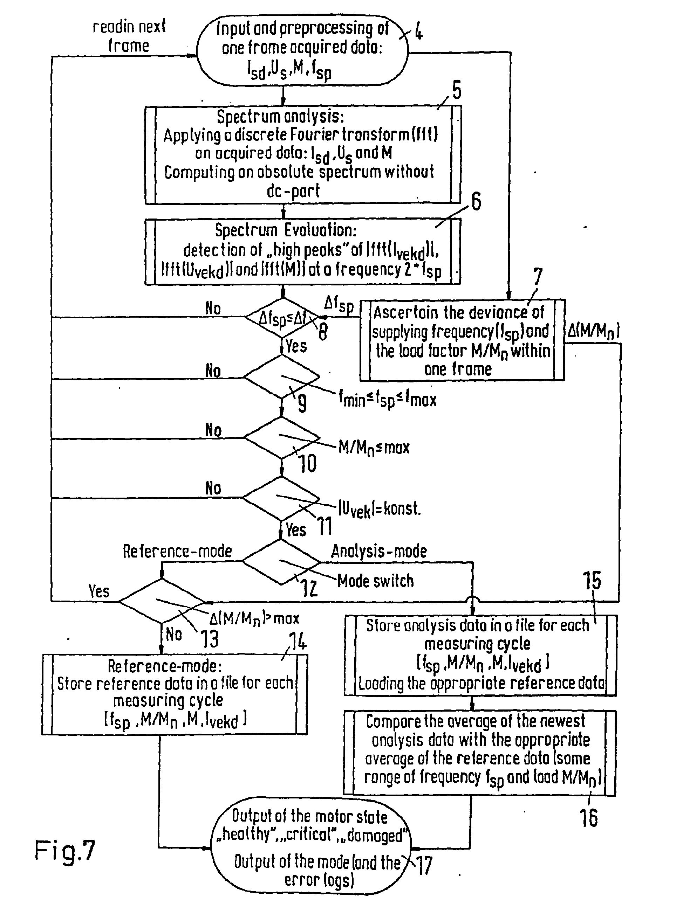

Fig. 7 zeigt schematisch in Form eines Flussdiagramms den Ablauf des Verfahrens beispielhaft für Statorwicklungsfehler. In einem Eingangsschritt 4 werden die benötigten Daten erfasst und zu einem "Frame" oder Datensatz zusammengefasst. Dabei handelt es sich um den Statorstrom I$_{sd}$, die Statorspannung U$_s$, das Drehmoment M und die

Speisespannung $f_{sp}$.

In einem darauf folgenden Schritt nimmt man eine Analyse des Spektrums vor, indem man eine diskrete Fourier-Transformation auf die daraus gewonnenen Daten $I_{vekd}$, $U_{vek}$ und M anwendet und ein absolutes Spektrum ohne Gleichanteil ermittelt.

In einem Schritt 6 wird das Spektrum bewertet. Man ermittelt Spitzen bei der kritischen Frequenz $2 \cdot f_{sp}$ der Stromkomponente $I_{vekd}$, der Spannung $U_{vek}$ und des Moments M.

Die in Schritt 4 gewonnenen Daten werden in einem Überwachungsschritt 7 daraufhin überprüft, ob die Speisefrequenz $f_{sp}$ und der Belastungsfaktor $M/M_n$ innerhalb eines "Frame" mit der notwendigen Genauigkeit konstant bleiben. Eine kleinere Abweichung $\Delta f_{sp}$ und $\Delta(M/M_n)$ sind zulässig.

In einem Prüfschritt 8 wird geprüft, ob die Speisefrequenz ausreichend konstant ist, d. h., ob $\Delta f_{sp}$ kleiner ist als ein vorgegebenes $\Delta f$. Wenn dies der Fall ist (yes), läuft das Verfahren weiter. Wenn dies nicht der Fall ist (no) wird der entsprechende Datensatz (Frame) verworfen.

In einem weiteren Schritt 9 wird geprüft, ob die Speisefrequenz $f_{sp}$ innerhalb eines zulässigen Frequenzbereichs liegt, der von $f_{min}$ bis $f_{max}$ reicht. Wenn dies der Fall ist, läuft das Verfahren weiter. Wenn dies nicht der Fall ist, wird der entsprechende Datensatz verworfen.

In einem weiteren Schritt 10 wird überprüft, ob sich der Motor im zulässigen Belastungsbereich bewegt, d. h., ob das Verhältnis zwischen dem aktuellen Moment M und dem Nennmoment $M_n$ kleiner ist als ein vorgegebener Maximalwert max. Wenn dies der Fall ist, wird das Verfahren fortgesetzt. Wenn dies nicht der Fall ist, wird der Datensatz verworfen.

In einem weiteren Prüfungsschritt wird geprüft, ob die Speisespannung $U_{vek}$ betragsmäßig konstant ist, d. h., ob die Phasenspannungen symmetrisch sind. Wenn dies der Fall ist, wird das Verfahren fortgesetzt. Wenn dies nicht der Fall ist, wird der entsprechende Datensatz verworfen.

In einem Schritt 12 wird die Betriebsart ausgewählt. In einer Referenz-Betriebsart (reference-mode) werden die Daten für den fehlerfreien Motor ermittelt. Dabei wird in einem Schritt 13 geprüft, ob das Drehmoment M in ausreichendem Maße konstant war. Wenn die Drehmomentschwankung $\Delta(M/M_n)$ einen bestimmten Maximalwert max überschreitet, wird der Datensatz verworfen. Wenn die Schwankung unterhalb dieses Werts ist, läuft das Verfahren weiter. In diesem Fall werden in einem Schritt 14 die entsprechenden Referenzdaten für jeden Messzyklus in einer Datei gespeichert. Dabei handelt es sich um die Daten Speisefrequenz $f_{sp}$, Lastfaktor $M/M_n$. Drehmoment M und flussbildende Stromkomponente $I_{vekd}$.

Wenn der Motor hingegen im späteren Betrieb analysiert wird, werden die zuvor ermittelten Messwerte Speisefrequenz $f_{sp}$, Lastverhältnis $M/M_n$, Drehmoment M und flussbildende Stromkomponente $I_{vekd}$ für jeden Messzyklus gespeichert und die entsprechenden Referenzdaten werden geladen. Hierzu ist ein Schritt 15 vorgesehen.

In einem Schritt 16 wird nun der Durchschnitt der neuesten Analysedaten verglichen mit einem geeigneten Durchschnitt der Referenzdaten. Hierbei verwendet man denselben Frequenzbereich der Speisefrequenz $f_{sp}$ und dasselbe Lastverhältnis $M/M_n$.

Aus diesem Vergleich kann man dann den Motorzustand in einem Schritt 17 ausgeben, wobei man im einfachsten Fall unterscheiden kann zwischen "gesund", "kritisch" und "beschädigt".

Diese Bewertung kann auch gespeichert werden.

## Patentansprüche

1. Verfahren zum Erfassen eines Fehlers in einer Drehfeldmaschine, bei dem man Stromkomponenten in einem flussfesten, insbesondere rotorflussfesten Koordinatensystem auswertet, wobei man eine flussbildende Stromkomponente ($i_{vekd}$) im flussfesten, insbesondere rotorflussfesten Koordinatensystem einer Frequenzanalyse unterzieht, **dadurch gekennzeichnet, dass** man für mindestens eine vorbestimmte Speisefrequenz ($f_{sp}$) einen aktuellen Betriebspunkt ermittelt und diesen Betriebspunkt mit einem früheren Betriebspunkt vergleicht.

2. Verfahren nach Anspruch 1, **dadurch gekennzeichnet, dass** der frühere Betriebspunkt einem fehlerfreien Zustand der Maschine entspricht.

3. Verfahren nach Anspruch 1 oder 2, **dadurch gekennzeichnet, dass** man für die Frequenzanalyse eine Fast-Fourier-Transformation verwendet.

4. Verfahren nach Anspruch 3, **dadurch gekennzeichnet, dass** man die Fast-Fourier-Transformation für Messwerte innerhalb eines Zeitfensters mit vorbestimmter Länge durchführt.

5. Verfahren nach Anspruch 4, **dadurch gekennzeichnet, dass** man die Speisefrequenz, ($f_{sp}$) innerhalb des Zeitfen-

sters konstant hält.

**6.** Verfahren nach Anspruch 4 oder 5, **dadurch gekennzeichnet, dass** man eine symmetrische betragsgleiche Spannung innerhalb des Zeitfensters beibehält.

**7.** Verfahren nach einem der Ansprüche 1 bis 6, **dadurch gekennzeichnet, dass** man mindestens eine Frequenz ($f_k$) berechnet und das Frequenzspektrum bei dieser kritischen Frequenz ($f_k$) auswertet.

**8.** Verfahren nach Anspruch 7, **dadurch gekennzeichnet, dass** man als kritische Frequenz ($f_k$) für einen Statorfehler

$$\mathbf{f_k} \ = \ \mathbf{2} \cdot f_{sp}$$

und für einen Rotorwicklungsfehler

$$\mathbf{f_k} \ = \ \mathbf{2} \cdot (f_{sp} - n \cdot p)$$

 ermittelt, wobei
$f_{sp}$ die Speisefrequenz,
n die Rotordrehzahl und
p die Anzahl der Polpaare ist.

**9.** Verfahren nach einem der Ansprüche 1 bis 8, **dadurch gekennzeichnet, dass** man die benötigten Größen aus Betriebsdaten eines Frequenzumrichters (3) gewinnt.

**Claims**

**1.** Method of detecting an error in a three-phase machine, said method comprising evaluation of current components in a fixed flux, in particular fixed rotor flux, coordinate system, a flux-forming current component ($i_{vekd}$) being subjected to a frequency analysis in the fixed flux, in particular fixed rotor flux, coordinate system, **characterised in that** for at least one predetermined supply frequency ($f_{sp}$) an actual operation point is determined and compared with a previous operation point.

**2.** Method according to claim 1, **characterised in that** the previous operation point corresponds to an error-free state of the machine.

**3.** Method according to claim 1 or 1, **characterised in that** for the frequency analysis a Fast-Fourier-Transformation is used.

**4.** Method according to claim 3, **characterised in that** the Fast-Fourier-Transformation is performed for measuring values within a time window with a predetermined duration.

**5.** Method according to claim 4, **characterised in that** within the time window the supply frequency ($f_{sp}$) is kept constant.

**6.** Method according to claim 4 or 5, **characterised in that** within the time window the value of the voltage is symmetrically maintained.

**7.** Method according to one of the claims 1 to 6, **characterised in that** at least one frequency ($f_k$) is calculated and the frequency spectre is evaluated at this critical frequency ($f_k$).

**8.** Method according to claim 7, **characterised in that** for a stator error the critical frequency ($f_k$) is calculated as:

$$f_k = 2 \cdot f_{sp}$$

and for a rotor winding error as:

$$f_k = 2 \cdot (f_{sp} - n \cdot p)$$

$f_{sp}$ being the supply frequency
n being the rotor speed
p being the number of pole pairs

9. Method according to one of the claims 1 to 8, **characterised in that** the required data are obtained from the operation data of a frequency converter (3).


**Revendications**

1. Procédé de détection d'une erreur dans une machine à induction, pour lequel on évalue des composantes de courant dans un système de coordonnées résistant au flux, en particulier résistant au flux rotorique, sachant qu'on soumet une composante de courant ($i_{vekd}$) formant le flux dans le système de coordonnées résistant au flux, en particulier résistant au flux rotorique, à une analyse de fréquence, **caractérisé en ce qu'**on calcule, pour au moins une fréquence d'alimentation prédéterminée ($f_{sp}$), un point de fonctionnement actuel et compare ce point de fonctionnement avec un point de fonctionnement antérieur.

2. Procédé selon la revendication 1, **caractérisé en ce que** le point de fonctionnement antérieur correspond à un état sans erreur de la machine.

3. Procédé selon la revendication 1 ou 2, **caractérisé en ce qu'**on utilise une transformée de Fourier rapide pour l'analyse de fréquence.

4. Procédé selon la revendication 3, **caractérisé en ce qu'**on réalise la transformée de Fourier rapide pour des valeurs de mesure dans une fenêtre de temps avec une longueur prédéterminée.

5. Procédé selon la revendication 4, **caractérisé en ce qu'**on stabilise la fréquence d'alimentation ($f_{sp}$) dans la fenêtre de temps.

6. Procédé selon la revendication 4 ou 5, **caractérisé en ce qu'**on maintient une tension symétrique de valeur identique dans la fenêtre de temps.

7. Procédé selon l'une quelconque des revendications 1 à 6, **caractérisé en ce qu'**on calcule au moins une fréquence ($f_k$) et évalue le spectre de fréquences pour cette fréquence critique ($f_k$).

8. Procédé selon la revendication 7, **caractérisé en ce qu'**on calcule comme fréquence critique ($f_k$) pour une erreur de stator

$$f_k = 2 \cdot f_{sp}$$

et pour une erreur d'enroulement rotorique

$$f_k = 2 \cdot (f_{sp} - n \cdot p)$$

sachant que
$f_{sp}$ est la fréquence d'alimentation,
n la vitesse de rotation du rotor et
p le nombre de paires de pôles.

**9.** Procédé selon l'une quelconque des revendications 1 à 8, **caractérisé en ce qu'**on obtient les grandeurs nécessaires à partir des données de fonctionnement d'un convertisseur de fréquence (3).

Fig.1

Fig.2

Fig.3

Fig.4

Fig.5

Fig.6

Fig.7

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5644458 A

- US 6822839 B2

**In der Beschreibung aufgeführte Nicht-Patentliteratur**

- Closed-loop Control Impact on the Diagnosis of Induction Motors Faults. *IEEE Transactions on Industry Applications,* September 2000, vol. 36 (5